# EUROPEAN PATENT SPECIFICATION

(11) **EP 2 731 146 B1**
(45) Date of publication and mention of the grant of the patent: **11.04.2018**
(21) Application number: 13183814.6
(22) Date of filing: 10.09.2013
(51) Int. Cl.: H01L 31/0224, H01L 31/068, H01L 31/18, H01L 31/028, H01L 31/0236

(54) **Photoelectric device and the manufacturing method thereof**
Photoelektrische Vorrichtung und Herstellungsverfahren
Dispositif photoélectrique et son procédé de fabrication

(30) Priority: 12.11.2012 US 201261725437 P
(43) Date of publication of application: 14.05.2014
(73) Proprietor: Intellectual Keystone Technology LLC, McLean, VA 22102 (US)
(72) Inventor: Lee, Doo-Youl, Chungcheongnam-do 331-300 (KR); Park, Sang-Jin, Gyeonggi-do (KR); Kang, Yoon-Mook, Gyeonggi-do (KR); Kim, Hyoeng-Ki, Chungcheongnam-do 331-300 (KR); Mo, Chan-Bin, Chungcheongnam-do 331-300 (KR); Park, Young-Sang, Chungcheongnam-Do 336-840 (KR); Seo, Kyoung-Jin, Chungcheongnam-Do 336-840 (KR); Kim, Min-Sung, Gyeonggi-do 446-711 (KR); Hong, Jun-Ki, Gyeonggi-do 446-711 (KR); Lim, Heung-Kyoon, Chungcheongnam-Do 336-840 (KR); Song, Min-Chul, Chungcheongnam-do 331-300 (KR); Park, Sung-Chan, Gyeonggi-do (KR); Kim, Dong-Seop, Gyeonggi-do (KR)
(74) Representative: Mounteney, Simon James

(56) References cited:
- EP-A2- 2 385 561
- WO-A2-2011/109058
- US-A1- 2002 182 895
- US-A1- 2007 256 728
- US-A1- 2009 308 438
- US-A1- 2012 073 650
- US-B1- 6 998 288
- US-B1- 7 468 485

## Description

One or more embodiments of the present invention relate to a photoelectric device and a method of manufacturing the same.

### [Related Art]

Currently, due to problems such as exhaustion of energy resources and environmental pollution of the earth, development of clean energy sources is accelerated. As a clean energy, photovoltaic energy generated using solar cells is directly transformed from sunlight and thus is regarded as a new energy source.

However, costs for generating photovoltaic energy that is currently industrially generated by using solar cells are high in comparison to generation of thermal energy, and power generation efficiency of the solar cells has to be increased to allow broader application of solar cells. In order to increase power generation efficiency, it is preferable that surface recombination loss and defects of an emitter and a base that separate and collect carriers generated by light absorption should be reduced.

Document US 6998288 B1 discloses a use of doped silicon dioxide in the fabrication of solar cells and US 2009/0308438 A1 discloses a trench process and a structure for backside contact solar cells with polysilicon doped regions.

### [Technical Goal of the Invention]

The present invention sets out to provide a photoelectric device in which carrier recombination loss due to defects of a semiconductor substrate is reduced, and an open-circuit voltage is increased.

### [Means for Achieving Technical Goal]

The subject matter of the present invention is defined in claims 1 and 8. According to a first aspect of the present invention, a photoelectric device includes the features of claim 1.

Such a device has improved carrier collection efficiency and hence photoelectric conversion efficiency because the doping unit is formed from monocrystalline silicon, which suffers fewer carrier recombination losses than the polycrystalline structures of the prior art (wherein recombination of electrons and holes is caused by grain boundaries).

Preferred features of this aspect of the invention are set out in claims 2 to 7.

A second aspect of the invention provides a method of manufacturing a photoelectric device according to claim 8.

The provision of the insulating layer enables part of the monocrystalline substrate to be used as the doping unit, hence avoiding the above-described disadvantages of polycrystalline silicon.

Preferred features of this aspect of the invention are set out in claims 9 to 15.

### [Effect of the Invention]

As described above, according to the one or more of the above embodiments of the present invention, a photoelectric device in which carrier recombination loss due to defects of a semiconductor substrate is reduced and an open-circuit voltage is increased may be provided. In particular, according to the present invention, an emitter and a base which separate and collect carriers are formed of monocrystalline silicon like a semiconductor substrate, and thus, carrier collecting efficiency may be increased, and photoelectric conversion efficiency may be improved.

### [Brief Description of the Drawings]

FIG. 1 illustrates a photoelectric device according to an embodiment of the present invention;
FIG. 2 illustrates a photoelectric device according to a comparative example of the present invention;
FIGS. 3A through 3C illustrate a method of manufacturing the photoelectric device of FIG. 2 according to the comparative example; and
FIGS. 4A through 4L illustrate a method of manufacturing a photoelectric device according to an embodiment of the present invention.

### [Description]

Reference will now be made in detail to embodiments of the invention, examples of which are illustrated in the accompanying drawings, wherein like reference numerals refer to the like elements throughout.

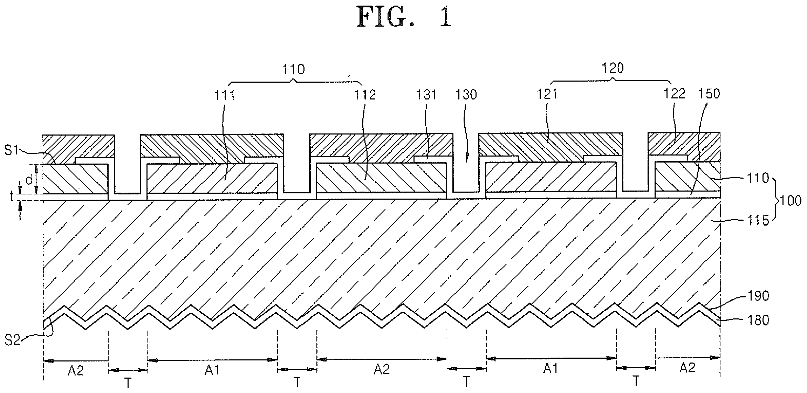

FIG. 1 illustrates a photoelectric device according to an embodiment of the present invention. Referring to FIG. 1, the photoelectric device includes a semiconductor substrate 100, first and second doping portions 111 and 112 formed in the semiconductor substrate 100, and first and second electrodes 121 and 122 that are electrically connected to the first and second doping portions 111 and 112. In this example, a plurality of the first and second doping portions 111 and 112 are alternately arranged along a first surface S1 of the semiconductor substrate 100 and within a common layer. The first and second doping portions 111 and 112 form a doping unit 110 of the semiconductor substrate 100. The first and second doping portions 111 and 112, which are adjacent to each other and have opposite conductivity types, do not contact each other but are insulated from each other through a trench 130.

Referring to FIG. 1, a first area A1 and a second area A2 are areas where the first and second doping portions 111 and 112 are formed. In addition, a trench area T in which the trench 130 is formed is interposed between the first and second areas A1 and A2.

The trench 130 is formed to insulate the first and second doping portions 111 and 112 having opposite conductivity types, from each other, and is formed, for example, from the first surface S1 of the semiconductor substrate 100 to a depth of the doping unit 110. According to this embodiment of the present invention, the trench 130 is formed to a depth of an insulating layer 150 formed at a predetermined depth d of the semiconductor substrate 100 to thereby provide insulation of the first and second doping portions 111 and 112. A trench insulating layer 131 is formed over a surface of the semiconductor substrate 100 that faces into the trench 130. The trench insulating layer 131 serves to passivate the covered surface of the semiconductor substrate 100, so as to reduce surface recombination loss.

The semiconductor substrate 100 includes the first surface S1 and a second surface S2 that is opposite to the first surface S1. A back-contact including electrodes 120 of both an emitter and a base is formed in the first surface S1, and the second surface S2 which does not include a structure of the electrodes 120 may function as a light-receiving surface, thereby increasing effective incident light and reducing light loss. By forming a back-contact where the electrode 120 is not formed, on the light-receiving surface of the semiconductor substrate 100 (i.e., the second surface S2), light loss due to the electrodes 120 may be reduced and high output may be obtained compared to conventional solar cells in which the electrode 120 is formed on a light-receiving surface.

By receiving light through the second surface S2, photogenerated carriers may be produced in the semiconductor substrate 100. The photogenerated carriers (hereinafter, "carriers") refer to holes and electrons that are produced as a result of light absorption by the semiconductor substrate 100. The semiconductor substrate 100 may be formed of a monocrystalline silicon substrate having an n-type or p-type conductivity type. For example, according to this embodiment of the present invention, the semiconductor substrate 100 is formed of an n-type monocrystalline silicon substrate. A texture structure 190 including uneven patterns is formed on the second surface S2 of the semiconductor substrate 100. The texture structure 190 has an uneven surface including a plurality of minute protrusions and reduces reflectivity of incident light.

A passivation layer 180 is formed on the textured second surface S2 of the semiconductor substrate 100. The passivation layer 180 may prevent recombination of carriers that are produced in the semiconductor substrate 100, thereby increasing carrier collecting efficiency.

The first and second doping portions 111 and 112 which have opposite conductivity types with respect to each other are formed at the first surface S1 of the semiconductor substrate 100. A plurality of the first and second doping portions 111 and 112 are arranged sequentially in a direction extending parallel to the first surface S1 of the semiconductor substrate 100 and alternate from one type to the other. The first and second doping portions 111 and 112 respectively function as an emitter and a base that separate and collect carriers produced in the semiconductor substrate 100. The first and second doping portions 111 and 112 are selectively formed in the first and second areas A1 and A2 of the first surface S1 of the semiconductor substrate 100.

The first doping portion 111 is formed of monocrystalline silicon, for example, monocrystalline silicon having the same lattice constant as that of the semiconductor substrate 100. The first doping portion 111 may be formed by implanting a p-type or n-type dopant into the semiconductor substrate 100. For example, the first doping portion 111 may be doped with a p-type which is opposite to the n-type semiconductor substrate 100, and may function as an emitter that collects minority carriers (e.g., holes) from the n-type semiconductor substrate 100.

The second doping portion 112 is formed of monocrystalline silicon, for example, monocrystalline silicon having the same lattice constant as that of the semiconductor substrate 100. The second doping portion 112 may be formed by implanting a p-type or n-type dopant into the semiconductor substrate 100. For example, the second doping portion 112 having an n-type conductivity type like the n-type semiconductor substrate 100 may be formed, and may function as a base that collects majority carriers (e.g., electrons) from the n-type semiconductor substrate 100.

The first and second doping portions 111 and 112 are separated by the trench 130 so as not to contact each other but to be electrically insulated from each other. That is, the trench 130 is formed between the first and second doping portions 111 and 112, and serves to insulate the first and second doping portions 111 and 112 from each other. The trench insulating layer 131 is formed on the surface of the semiconductor substrate 100 that is exposed by the trench 130. The trench insulating layer 131 may passivate the surface of the semiconductor substrate 100 that is exposed by the trench 130.

The first and second doping portions 111 and 112 form the doping unit 110 of the semiconductor substrate 100. The doping unit 110 of the semiconductor substrate 100 is formed in a surface of the semiconductor substrate 100 and of monocrystalline silicon having the same lattice constant as that of a main body 115 of the semiconductor substrate 100. As the first and second doping portions 111 and 112 which separate and collect photogenerated carriers are formed of monocrystalline silicon, defects of the first and second doping portions 111 and 112 may be minimized, and loss due to defects such as carrier trapping may be reduced.

According to this embodiment of the present invention, the doping unit 110 is a portion of the semiconductor substrate 100 and is formed of monocrystalline silicon. Thus, the doping unit 110 is not an epitaxial layer that is epitaxially grown on the surface of the semiconductor substrate 100 but is formed as a portion of the monocrystalline semiconductor substrate 100. As will be described later, the insulating layer 150 is formed between the doping unit 110 and the main body 115 of the semiconductor substrate 100, and the insulating layer 150 may be formed at a predetermined depth d from the surface of the semiconductor substrate 100 by ion implantation, and the doping unit 110 including the first and second doping portions 111 and 112 may be formed by diffusing p-type or n-type dopants into the surface of the semiconductor substrate 100.

The doping unit 110 is formed on the first surface S1 of the semiconductor substrate 100, and the insulating layer 150 is formed between the doping unit 110 and the second surface S2 of the semiconductor substrate 100. The insulating layer 150 may passivate the semiconductor substrate 100 so as to reduce carrier recombination loss due to defects of the semiconductor substrate 100 and improve carrier collecting efficiency, and accordingly, an open-circuit voltage of the photoelectric device may be increased.

For example, while being formed or through passivation of the semiconductor substrate 100, the insulating layer 150 may spontaneously have characteristics of positive fixed charges or negative fixed charges. For example, the insulating layer 150 may have characteristics of positive fixed charges, and prevent access of holes which are minority carriers of the n-type semiconductor substrate 100, thereby increasing the life span of the minority carriers. For example, the insulating layer 150 may be formed of a silicon oxide layer or a silicon nitride layer, but the embodiments of the present invention are not limited thereto.

According to an embodiment of the present invention, the insulating layer 150 may be formed by ion implantation, and by this ion implantation, the insulating layer 150 may be formed at a predetermined depth d between the first surface S1 and the second surface S2 of the semiconductor substrate 100. For example, the insulating layer 150 may be formed of a silicon oxide layer that is formed by ion implantation of oxygen ions.

In the ion implantation, ions are caused to penetrate through from the surface of the semiconductor substrate 100 to a desired depth by controlling a projection range which is a lineal distance that ions are projected from the surface of the semiconductor substrate 100, and the depth d or a thickness t of the insulating layer 150 may be precisely adjusted. Also, by controlling the projection range, a profile of an ion concentration according to a depth direction of the semiconductor substrate 100 may be adjusted. The projection range may be adjusted according to the amount of energy that accelerates ion beams during ion implantation. Also, by controlling an ion dose that is implanted during the ion implantation, a composition of the insulating layer 150 or a profile of an ion concentration may be precisely adjusted.

By controlling process conditions of ion implantation such as the projection range and ion dose, the thickness t of the insulating layer 150 may be precisely adjusted, and the insulating layer 150 having uniform insulating characteristics over the whole semiconductor substrate 100 may be formed, and tunneling of carriers through the insulating layer 150 may also be maintained uniformly.

According to an embodiment of the present invention, the insulating layer 150 may have the thickness t of about 5A to 30Å. If the insulating layer 150 is thicker than the above range, tunneling of carriers is difficult, and thus collection of carriers by using the first and second semiconductor layers 111 and 112 is also difficult; if the insulating layer 150 is thinner than the above range, the insulating layer 150 may not substantially perform the function of passivation, and this makes it difficult to increase an open-circuit voltage. Meanwhile, according to an embodiment of the present invention, the insulating layer 150 may be formed at a depth d of about 2000 Å to about 3000 Å from the surface of the semiconductor substrate 100.

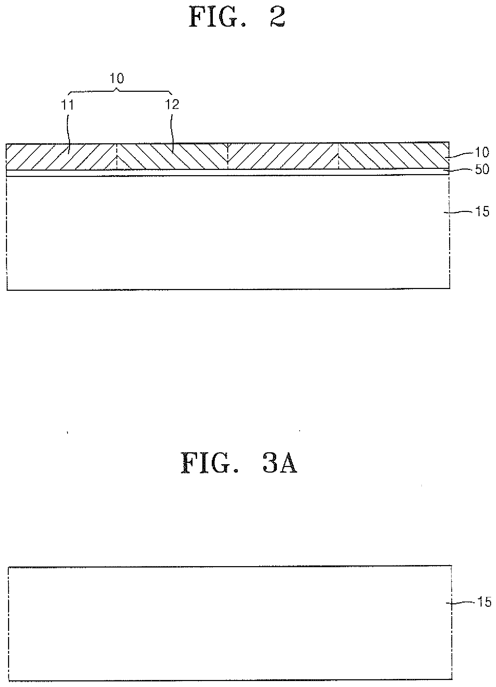

FIG. 2 illustrates a photoelectric device according to a comparative example of the present invention. Referring to FIG. 2, a doping unit 10 is formed on a semiconductor substrate 15, and an insulating layer 50 is formed between the semiconductor substrate 15 and the doping unit 10. The doping unit 10 is formed of polycrystalline silicon or amorphous silicon.

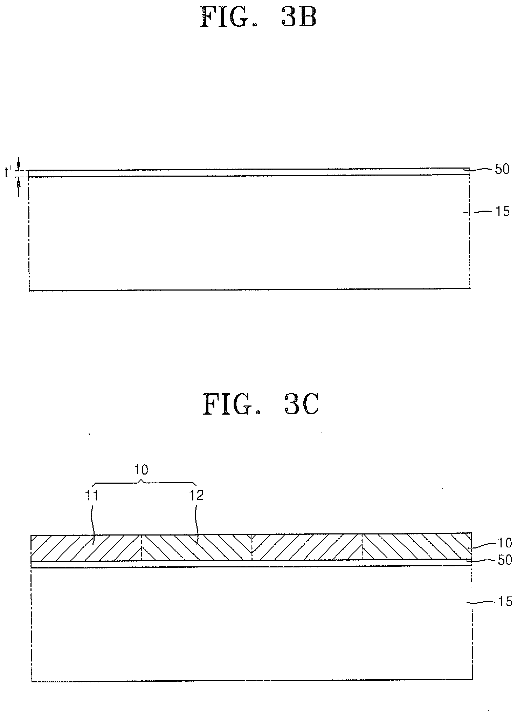

FIGS. 3A through 3C illustrate a method of manufacturing the photoelectric device of FIG. 2 according to the comparative example. Referring to FIGS. 3A through 3C, the insulating layer 50 having a predetermined thickness t is formed on the semiconductor substrate 15 by using a thermal oxidizing operation (see FIG. 3B), and the doping unit 10 including first and second semiconductor layers 11 and 12 having opposite conductivity types are formed on the insulating layer 50 (see FIG. 3C). As the first and second semiconductor layers 11 and 12 are formed on the insulating layer 50 that covers the semiconductor substrate 15, they may not be formed of monocrystalline silicon, but of polycrystalline silicon or amorphous silicon by using a deposition method such as a chemical vapor deposition (CVD) method. However, polycrystalline silicon or amorphous silicon includes various defects such as lattice defects of crystals. For example, carrier recombination loss and a decrease in photoelectric conversion efficiency may be caused.

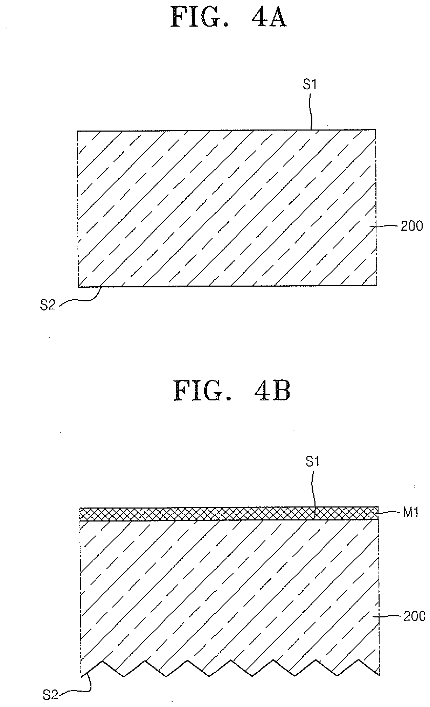

Hereinafter, a method of manufacturing a photoelectric device according to an embodiment of the present invention will be described with reference to FIGS. 4A through 4L.

First, as illustrated in FIG. 4A, a semiconductor substrate 200 is provided. For example, the semiconductor substrate 200 may be formed using an n-type or p-type monocrystalline silicon wafer. To remove physical or chemical impurities attached on a surface of the semiconductor substrate 200, a cleansing operation using an acid solution or an alkali solution may be performed.

Next, as illustrated in FIG. 4B, a mask M1 is formed on a first surface S1 of the semiconductor substrate 200. The mask M1 functions as an etch stopper layer that protects the first surface S1 of the semiconductor substrate 200 when performing texturing for forming uneven patterns in a second surface S2 of the semiconductor substrate 200.

Next, as illustrated in FIG. 4B, texturing is performed on the second surface S2 of the semiconductor substrate 200. The second surface S2 of the semiconductor substrate 200 is etched by using the mask M1 formed on the first surface S1 of the semiconductor substrate 200. For example, anisotropic etching in which an alkali solution is used may be performed with respect to the semiconductor substrate 200 so as to form a texture structure of uneven patterns in the second surface S2 of the semiconductor substrate 200.

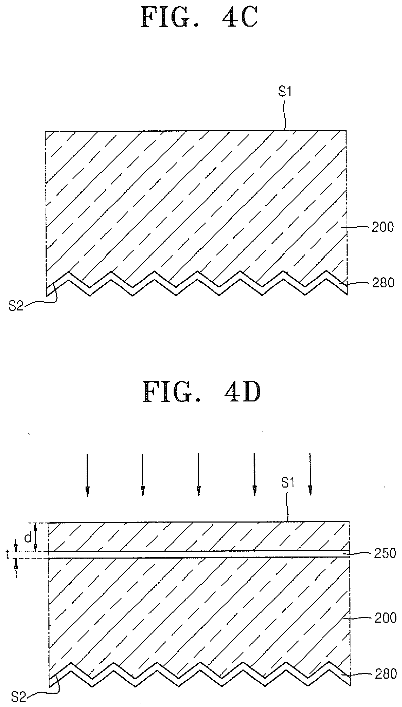

Next, as illustrated in FIG. 4C, a passivation layer 280 is formed on the second surface S2 of the semiconductor substrate 200. The passivation layer 280 may prevent surface recombination of carriers that are produced in the semiconductor substrate 200 to thereby improve carrier collecting efficiency. For example, the passivation layer 280 may be formed of an intrinsic semiconductor layer, a doped semiconductor layer, a silicon oxide layer (SiOx), or a silicon nitride layer (SiNx).

Next, as illustrated in FIG. 4D, an insulating layer 250 is formed on the semiconductor substrate 200 by ion implantation. The ion implantation is performed with respect to the first surface S1 of the semiconductor substrate 200, and the insulating layer 250 is formed over the entire area of the semiconductor substrate 200. In this example, the insulating layer 250 may be formed of a silicon oxide layer by ion implantation of oxygen ions.

When performing the ion implantation, by controlling process conditions such as a projection range and an ion dose, ions may penetrate through from the surface of the semiconductor substrate 200 to a desired depth, and a depth d at which the insulating layer 250 is formed and a thickness t of the insulating layer 250 may be precisely controlled. In detail, according to an embodiment of the present invention, the insulating layer 250 may be formed at a depth d of about 2000 Å to 3000 Å from the surface of the semiconductor substrate 200 and may have a thickness t of about 5Å to 30Å.

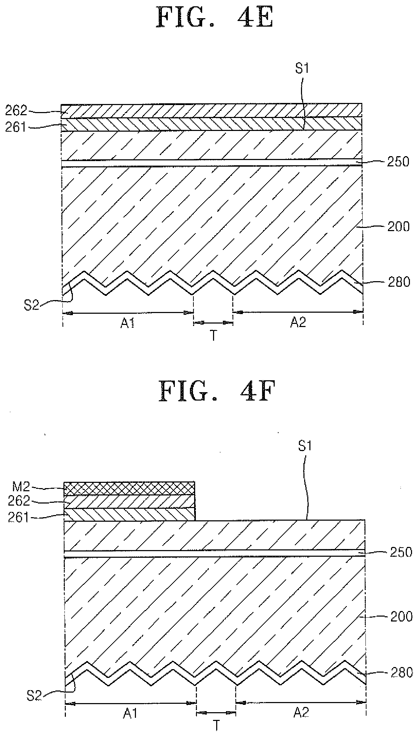

Next, as illustrated in FIG. 4E, a first doping material layer 261 is formed on the first surface S1 of the semiconductor substrate 200. In this embodiment, the first doping material layer 261 is formed over the entire area of the semiconductor substrate 200 including first and second areas A1 and A2 and a trench area T.

The first doping material layer 261 may be formed of a silicon oxide layer including a p-type or n-type dopant, and may include, for example, a p-type dopant which has a reverse conductivity type to the n-type semiconductor substrate 200. The first doping material layer 261 may be formed using a CVD method, and may be formed of, for example, phosphorous silicate glass (PSG). As will be described later, the dopant of the first doping material layer 261 diffuses toward the semiconductor substrate 200 by drive-in, and a first semiconductor layer 211 is formed in a surface of the semiconductor substrate 200.

Next, as illustrated in FIG. 4E, a first diffusion barrier layer 262 is formed on the first doping material layer 261. The first diffusion barrier layer 262 may prevent diffusion of the dopant of the first doping material layer 261 in a reverse direction during drive-in, which will be described later. For example, a silicon oxide layer not including a p-type or n-type dopant may be applied as the first diffusion barrier layer 262.

Next, as illustrated in FIG. 4F, the first doping material layer 261 and the first diffusion barrier layer 262 are patterned. That is, an area except the first area A1 is removed, and the first doping material layer 261 and the first diffusion barrier layer 262 formed in the second area A2 and the trench area T are removed by etching. In detail, a mask M2 is applied on the first area A1, and portions exposed through the mask M2 are removed. When etching is completed, the used mask M2 is removed.

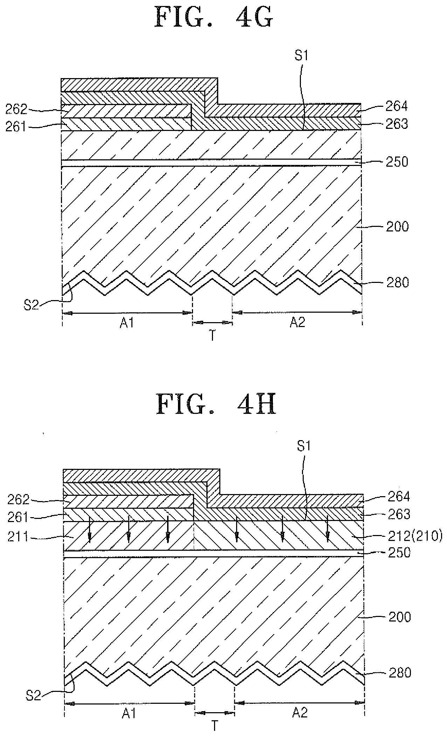

Next, as illustrated in FIG. 4G, a second doping material layer 263 is formed on the semiconductor substrate 200. The second doping material layer 263 may be formed of a silicon oxide layer including a p-type or n-type dopant, and may include, for example, an n-type dopant which has the same conductivity type as the n-type semiconductor substrate 200. The second doping material layer 263 may be formed using a CVD method, and may be formed of, for example, boron silicate glass (BSG). As will be described later, the dopant of the second doping material layer 263 diffuses to the semiconductor substrate 200 by drive-in, and a second semiconductor layer 212 is formed in the surface of the semiconductor substrate 200. The second doping material layer 263 may be formed over the entire area of the semiconductor substrate 200 including the second area A2.

Next, as illustrated in FIG. 4G, a second diffusion barrier layer 264 is formed on the second doping material layer 263. The second diffusion barrier layer 264 may prevent diffusion of the dopant of the second doping material layer 263 in a reverse direction during drive-in, which will be described later. For example, a silicon oxide layer not including a p-type or n-type dopant may be applied as the second diffusion barrier layer 264.

Next, as illustrated in FIG. 4H, in order that the dopants of the first and second material layers 261 and 263 formed on the semiconductor substrate 200 may quickly diffuse into the semiconductor substrate 200, drive-in is performed. During the drive-in, the semiconductor substrate 200 is maintained at a high temperature without additional implantation of a doping material. For example, the dopant of the first doping material 261 diffuses into the first area A1 of the semiconductor substrate 200, and the first doping portion 211 is formed in the first area A1. In addition, the dopant of the second doping material layer 263 diffuses into the second area A2 of the semiconductor substrate 200, and the second doping portion 212 is formed in the second area A2. The first and second doping portions 211 and 212 together form a doping unit 210 of the semiconductor substrate 200.

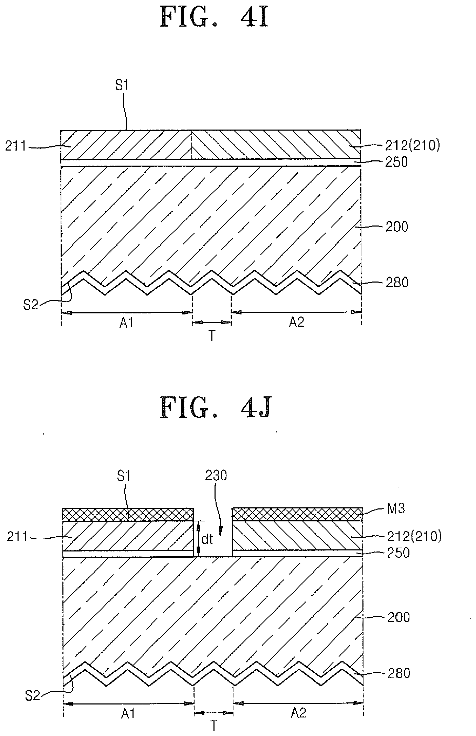

Next, as illustrated in FIG. 4I, etch-back for removing the first and second doping material layers 261 and 263 and the first and second diffusion barrier layers 262 and 264 is performed. The first and second doping material layers 261 and 263 include a precipitate of metal impurities contained in the semiconductor substrate 200, and thus, by removing the precipitate, the effect of gettering of removing the impurities may be provided. During the etch-back, the first and second doping material layers 261 and 263 and the first and second diffusion barrier layers 262 and 264 may be removed simultaneously or sequentially.

Next, as illustrated in FIG. 4J, a trench 230 is formed between the first and second doping portions 211 and 212 such that the first and second doping portions 211 and 212 do not contact each other but are insulated from each other. The trench 230 is formed at a predetermined depth dt from the first surface S1 of the semiconductor substrate 200; the trench 230 is formed at least to a depth corresponding to the doping unit 210 of the semiconductor substrate 200 to thereby separate the first and second doping portions 211 and 212. According to this embodiment of the present invention, the trench 230 is formed to the depth dt to pass through the doping unit 210 and the insulating layer 250 of the semiconductor substrate 200, thereby providing insulation between the first and second doping portions 211 and 212. In order to control the depth dt of the trench 230, a process time may be adjusted in consideration of an etching speed according to an etchant, or an additional etching stopper layer may be formed in the semiconductor substrate 200 by ion implantation or the like.

For example, the trench 230 is formed to a depth dt corresponding to the doping unit 210 and the insulating layer 250 by forming a mask M3 on the first and second areas A1 and A2 of the semiconductor substrate 200 and etching portions of the doping unit 210 and the insulating layer 250 corresponding to an area between the first and second areas A1 and A2 that is exposed through the mask M3, to the predetermined depth dt of the semiconductor substrate 200. The trench 230 may be formed by sequentially removing the portions of the doping unit 210 and the insulating layer 250 between the first area A1 and the second area A2. Accordingly, the first and second doping portions 211 and 212 of the first and second areas A1 and A2 may be separated and electrically insulated from each other. When etching is completed, the used etching mask M3 is removed.

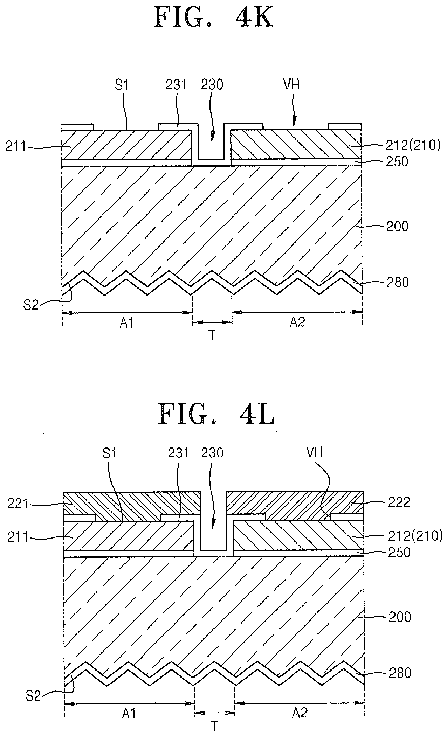

Next, as illustrated in FIG. 4K, a trench insulating layer 231 is formed along a surface of the semiconductor substrate 200 that is exposed through the trench 230. The trench insulating layer 231 serves to passivate the semiconductor substrate 200, remove surface defects of the semiconductor substrate 200, and reduce loss due to recombination of carriers. For example, the trench insulating layer 231 may be formed at least in the trench area T to cover the trench surface, and may also be extended up to portions of the first and second areas A1 and A2 that are adjacent to the trench area T.

According to this embodiment of the present invention, the trench insulating layer 231 is formed on the entire area of the first surface S1 of the semiconductor substrate 200 including the first and second areas A1 and A2 and the trench area T, and a via hole VH through which the first and second doping portions 211 and 212 and the first and second electrodes 221 and 222 are electrically connected to each other may be formed by removing a portion of the first and second areas A1 and A2 of the trench insulating layer 231 that is formed over the entire area of the semiconductor substrate 200. For example, the trench insulating layer 231 may be formed of a silicon oxide layer SiOx or a silicon nitride layer SiNx and by using thermal oxidization or deposition.

Next, as illustrated in FIG. 4L, first and second electrodes 221 and 222 whereby collected carriers are withdrawn to the outside may be formed on the first and second semiconductor layers 211 and 212, respectively. The first and second electrodes 221 and 222 may include a metal such as silver (Ag), aluminum (AI), copper (Cu), or nickel (Ni). For example, the first and second electrodes 221 and 222 may be formed by pattern-printing a metal paste by screen printing and thermally curing the patterned metal paste. For example, the first and second electrodes 221 and 222 may be respectively electrically connected to the first and second doping portions 211 and 212 via the via hole VH.

According to another embodiment of the present invention, a transparent conductive oxide (TCO) layer (not shown) may be interposed between the first and second doping portions 211 and 212 and the first and second electrodes 221 and 222.

It should be understood that the embodiments described herein should be considered in a descriptive sense only and not for purposes of limitation. Descriptions of features or aspects within each embodiment should typically be considered as available for other similar features or aspects in other embodiments.

## Claims

1. A photoelectric device comprising:
a semiconductor substrate (100) formed of monocrystalline silicon and having first and second surfaces (S1, S2) that are opposite to each other;
a doping unit (110) formed at the first surface of the semiconductor substrate;
an insulating layer (150) ; and
first and second electrodes (121, 122) formed on the doping unit (110);
**characterised in that** the doping unit includes a first doping portion (111) including a first dopant doped in the monocrystalline silicon, and a second doping portion (112) including a second dopant doped in the monocrystalline silicon;
the first electrode (121) is formed on the first doping portion (111) and the second electrode (122) is formed on the second doping portion (112); and
the insulating layer (150) is formed at a predetermined depth from the first surface between the doping unit (110) and the second surface of the semiconductor substrate by ion implantation.

2. A photoelectric device according to claim 1, wherein the first doping portion (111) and the second doping portion (112) have mutually opposite conductivity types and are arranged sequentially in a first direction extending parallel to the said first surface (S1) of the semiconductor substrate.

3. A photoelectric device according to claim 1 or 2, wherein the insulating layer is a silicon oxide layer.

4. A photoelectric device according to any preceding claim, wherein the first and second doping portions (111, 112) are separated from each other by a trench (130).

5. A photoelectric device according to claim 4, wherein the trench (130) extends through the first surface (S1) of the semiconductor substrate (100), the doping unit (110) and the insulating layer (150).

6. A photoelectric device according to claim 4 or 5, wherein a trench insulating layer (131) is provided over a surface of the semiconductor substrate that faces into the trench (130).

7. A photoelectric device according to any preceding claim, wherein the first doping portion (111) and the second doping portion (112) are arranged in a common layer.

8. A method of manufacturing a photoelectric device comprising:
providing a semiconductor substrate (200) formed of monocrystalline silicon and having first and second surfaces (S1, S2) that are opposite to each other;
forming an insulating layer (250); and
forming a doping unit (210) between the first surface of the semiconductor substrate (200) and the insulating layer (250);
**characterised in that** forming the doping unit (210) comprises doping a first dopant in the monocrystalline silicon to form a first doping portion (211) inside the semiconductor substrate (200), and doping a second dopant in the monocrystalline silicon to form a second doping portion (212) inside the semiconductor substrate (200); and
the insulating layer (250) is formed between the first and second surfaces of the semiconductor substrate by implanting ions into the first surface (S1) of the semiconductor substrate to a predetermined depth from the first surface.

9. A method according to claim 8, wherein the first doping portion (211) and the second doping portion (212) are formed to have mutually opposite conductivity types and are formed at locations that are arranged sequentially in a first direction extending parallel to the said first surface (S1) of the semiconductor substrate (200).

10. A method according to claim 8 or 9, wherein a trench (230) is formed between the first doping portion (211) and the second doping portion (212) after forming the doping unit (210).

11. A method according to claim 10, wherein the trench (230) is formed to extend through the first surface (S1) of the semiconductor substrate, the doping unit (210) and the insulating layer (250).

12. A method according to claim 10 or 11, wherein a trench insulating layer (231) is formed over a surface of the semiconductor substrate (200) that faces into the trench (230).

13. A method according to any one of claims 8 to 12, wherein the formation of the doping unit (210) includes:
forming a first doping material layer (261) on the first surface (S1) of the semiconductor substrate (200);
patterning the first doping material layer (261) to correspond to an area (A1) in which the first doping portion is to be formed, by removing a portion of the first doping material layer by etching;
forming a second doping material layer (263) on the first surface of the semiconductor substrate; and
diffusing dopants of the first and second doping material layers into (261, 263) the semiconductor substrate by drive-in.

14. A method according to claim 13, wherein the first and second dopants are diffused into the semiconductor substrate (200) to the depth of the insulating layer (250).

15. A method according to claim 13 or 14, comprising providing a first barrier layer (262) over the first doping material layer (261) and providing a second barrier layer (264) over the second doping material layer (263) before diffusing the dopants of the first and second doping material layers into the semiconductor substrate (200).

## Patentansprüche

1. Photoelektrische Vorrichtung umfassend:
ein Halbleitersubstrat (100), welcher aus monokristallinem Silizium gebildet ist und eine erste und zweite Oberfläche (S1, S2) aufweist, welche sich gegenüberstehen;
eine Dotiereinheit (110), welche an der ersten Oberfläche des Halbleitersubstrats gebildet ist;
eine Isolierschicht (150); und
eine erste und zweite Elektrode (121,122), welche auf der Dotiereinheit (110) gebildet sind;
**dadurch gekennzeichnet, dass** die Dotiereinheit einen ersten Dotierabschnitt (111) umfasst, welcher ein erstes Dotiermittel umfasst, welches im monokristallinen Silizium dotiert ist, und einen zweiten Dotierabschnitt (112), welcher ein zweites Dotiermittel umfasst, welches im monokristallinen Silizium dotiert ist;
wobei die erste Elektrode (121) auf dem ersten Dotierabschnitt (111) und die zweite Elektrode (122) auf dem zweiten Dotierabschnitt (112) gebildet ist; und
die Isolierschicht (150) in einer vorbestimmten Tiefe relativ zur ersten Oberfläche zwischen der Dotiereinheit (110) und der zweiten Oberfläche des Halbleitersubstrats durch Ionenimplantierung gebildet ist.

2. Photoelektrische Vorrichtung nach Anspruch 1, wobei der erste Dotierabschnitt (111) und der zweite Dotierabschnitt (112) entgegengesetzte Leitfähigkeitstypen aufweisen und nacheinander in einer ersten Richtung angeordnet sind, welche sich parallel zur ersten Oberfläche (S1) des Halbleitersubstrats erstreckt.

3. Photoelektrische Vorrichtung nach Anspruch 1 oder 2, wobei die Isolierschicht eine Siliziumoxidschicht ist.

4. Photoelektrische Vorrichtung nach einem der vorhergehenden Ansprüche, wobei der erste und zweite Dotierabschnitt (111, 112) durch einen Graben (130) voneinander getrennt sind.

5. Photoelektrische Vorrichtung nach Anspruch 4, wobei der Graben (130) sich durch die erste Oberfläche (S1) des Halbleitersubstrats (100), die Dotiereinheit (110) und die Isolierschicht (150) erstreckt.

6. Photoelektrische Vorrichtung nach Anspruch 4 oder 5, wobei eine Grabenisolierschicht (131) über eine Oberfläche des Halbleitersubstrats bereitgestellt ist, welche dem Graben (130) zugewandt ist.

7. Photoelektrische Vorrichtung nach einem der vorhergehenden Ansprüche, wobei der erste Dotierabschnitt (111) und der zweite Dotierabschnitt (112) in einer gemeinsamen Schicht angeordnet sind.

8. Verfahren zum Herstellen einer photoelektrischen Vorrichtung umfassend:
Bereitstellen eines Halbleitersubstrats (200), welcher aus monokristallinem Silizium gebildet ist und eine erste und zweite Oberfläche (S1, S2) aufweist, welche einander gegenüberliegen;
Bilden einer Isolierschicht (250); und
Bilden einer Dotiereinheit (210) zwischen der ersten Oberfläche des Halbleitersubstrats (200) und der Isolierschicht (250);
**dadurch gekennzeichnet, dass** das Bilden der Dotiereinheit (210) das Dotieren eines ersten Dotiermittels in das monokristalline Silizium, um einen ersten Dotierabschnitt (211) innerhalb des Halbleitersubstrats (200) zu bilden, und das Dotieren eines zweiten Dotiermittels in das monokristalline Silizium umfasst, um einen zweiten Dotierabschnitt (212) innerhalb des Halbleitersubstrats (200) zu bilden; und
die Isolierschicht (250) zwischen der ersten und zweiten Oberfläche des Halbleitersubstrats durch Ionenimplantierung in die erste Oberfläche (S1) des Halbleitersubstrats bis zu einer vorbestimmten Tiefe relativ zur ersten Oberfläche gebildet ist.

9. Verfahren nach Anspruch 8, wobei der erste Dotierabschnitt (211) und der zweite Dotierabschnitt (212) so gebildet sind, dass sie entgegengesetzte Leitfähigkeitstypen aufweisen und in Positionen gebildet sind, welche nacheinander in einer ersten Richtung angeordnet sind, welche sich parallel zu der ersten Oberfläche (S1) des Halbleitersubstrats (200) erstreckt.

10. Verfahren nach Anspruch 8 oder 9, wobei ein Graben (230) zwischen dem ersten Dotierabschnitt (211) und dem zweiten Dotierabschnitt (212) nach dem Bilden der Dotiereinheit (210) gebildet ist.

11. Verfahren nach Anspruch 10, wobei der Graben (230) so geformt ist, dass er sich durch die erste Oberfläche (S1) des Halbleitersubstrats, die Dotiereinheit (210) und die Isolierschicht (250) erstreckt.

12. Verfahren nach Anspruch 10 oder 11, wobei eine Grabenisolierschicht (231) über eine Oberfläche des Halbleitersubstrats (200) gebildet ist, welche dem Graben (230) zugewandt ist.

13. Verfahren nach einem der Ansprüche 8 bis 12, wobei das Bilden der Dotiereinheit (210) umfasst:
Bilden einer ersten Dotiermaterialschicht (261) auf der ersten Oberfläche (S1) des Halbleitersubstrats (200);
Strukturieren der ersten Dotiermaterialschicht (261), entsprechend eines Bereichs (A1), in welchem der erste Dotierabschnitt gebildet werden muss, durch Entfernen eines Abschnitts der ersten Dotiermaterialschicht durch Ätzen;
Bilden einer zweiten Dotiermaterialschicht (263) auf der ersten Oberfläche des Halbleitersubstrats; und
Diffundieren von Dotiermitteln der ersten und zweiten Dotiermaterialschicht (261, 263) in das Halbleitersubstrat durch Eintreiben.

14. Verfahren nach Anspruch 13, wobei das erste und zweite Dotiermittel in das Halbleitersubstrat (200) bis zu der Tiefe der Isolierschicht (250) diffundiert werden.

15. Verfahren nach Anspruch 13 oder 14, umfassend das Bereitstellen einer ersten Sperrschicht (262) über die erste Dotiermaterialschicht (261) und das Bereitstellen einer zweiten Sperrschicht (264) über die zweite Dotiermaterialschicht (263) bevor die Dotiermittel der ersten und zweiten Dotiermaterialschicht in das Halbleitersubstrat (200) diffundiert werden.

## Revendications

1. Dispositif photoélectrique, comprenant :
un substrat semi-conducteur (100) formé à partir de silicium monocristallin et présentant des première et deuxième surfaces (S1, S2) se trouvant à l'opposé l'une de l'autre ;
l'unité de dopage (110) formée au niveau de la première surface du substrat semi-conducteur ;
une couche isolante (150) ; et
des première et deuxième électrodes (121, 122) formées sur l'unité de dopage (110) ;
**caractérisé en ce que** l'unité de dopage comprend une première partie dopage (111) comprenant un premier dopant incorporé dans le silicium monocristallin, et une deuxième partie dopage (112) comprenant un deuxième dopant incorporé dans le silicium monocristallin ;
la première électrode (121) étant formée sur la première partie dopage (111) et la deuxième électrode (122) étant formée sur la deuxième partie dopage (112) ; et
la couche isolante (150) étant formée à une profondeur prédéterminée par rapport à la première surface entre l'unité de dopage (110) et la deuxième surface du substrat semi-conducteur par implantation ionique.

2. Dispositif photoélectrique selon la revendication 1, dans lequel la première partie dopage (111) et la deuxième partie dopage (112) présentent des types de conductivité mutuellement opposés et sont agencées de manière successive dans une première direction s'étendant parallèlement par rapport à ladite première surface (S1) du substrat semi-conducteur.

3. Dispositif photoélectrique selon la revendication 1 ou 2, dans lequel la couche isolante est une couche d'oxyde de silicium.

4. Dispositif photoélectrique selon l'une quelconque des revendications précédentes, dans lequel les première et deuxième parties dopage (111, 112) sont séparées l'une de l'autre par une tranchée (130).

5. Dispositif photoélectrique selon la revendication 4, dans lequel la tranchée (130) s'étend à travers la première surface (S1) du substrat semi-conducteur (100), l'unité de dopage (110) et la couche isolante (150).

6. Dispositif photoélectrique selon la revendication 4 ou 5, dans lequel une couche d'isolation de tranchée (131) est fournie par-dessus une surface du substrat semi-conducteur qui regarde vers la tranchée (130).

7. Dispositif photoélectrique selon l'une quelconque des revendications précédentes, dans lequel la première partie dopage (111) et la deuxième partie dopage (112) sont agencées dans une couche commune.

8. Procédé de fabrication d'un dispositif photoélectrique, comprenant les étapes consistant à :
fournir un substrat semi-conducteur (200) formé à partir de silicium monocristallin et présentant des première et deuxième surfaces (S1, S2) se trouvant à l'opposé l'une de l'autre ;
former une couche isolante (250) ; et
former une unité de dopage (210) entre la première surface du substrat semi-conducteur (200) et la couche isolante (250) ;
**caractérisé en ce que** la formation de l'unité de dopage (210) comprend les étapes consistant à incorporer un premier dopant dans le silicium monocristallin afin de former une première partie dopage (211) à l'intérieur du substrat semi-conducteur (200), et incorporer un deuxième dopant dans le silicium monocristallin afin de former une deuxième partie dopage (212) à l'intérieur du substrat semi-conducteur (200) ; et
la couche isolante (250) est formée entre les première et deuxième surfaces du substrat semi-conducteur grâce à une étape consistant à implanter des ions dans la première surface (S1) du substrat semi-conducteur jusqu'à une profondeur prédéterminée par rapport à la première surface.

9. Procédé selon la revendication 8, dans lequel la première partie dopage (211) et la deuxième partie dopage (212) sont formées de manière à présenter des types de conductivité mutuellement opposés et sont formées au niveau d'emplacements qui sont agencés de manière successive dans une première direction s'étendant parallèlement à ladite première surface (S1) du substrat semi-conducteur (200).

10. Procédé selon la revendication 8 ou 9, dans lequel une tranchée (230) est formée entre la première partie dopage (211) et la deuxième partie dopage (212) après formation de l'unité de dopage (210).

11. Procédé selon la revendication 10, dans lequel la tranchée (230) est formée de manière à s'étendre à travers la première surface (S1) du substrat semi-conducteur, l'unité de dopage (210), et la couche isolante (250).

12. Procédé selon la revendication 10 ou 11, dans lequel une couche isolante de tranchée (231) est formée par-dessus une surface du substrat semi-conducteur (200) qui regarde vers la tranchée (230).

13. Procédé selon l'une quelconque des revendications 8 à 12, dans lequel la formation de l'unité de dopage (210) comprend les étapes consistant à :
former une première couche de matériau de dopage (261) sur la première surface (S1) du substrat semi-conducteur (200) ;
structurer la première couche de matériau de dopage (261) afin qu'elle corresponde à une zone (A1) au sein de laquelle la première partie dopage doit être formée, grâce à une étape consistant à retirer une partie de la première couche de matériau de dopage par gravure ;
former une deuxième couche de matériau de dopage (263) sur la première surface du substrat semi-conducteur ; et
diffuser des dopants appartenant aux première et deuxième couches de matériau de dopage (261, 263) dans le substrat semi-conducteur par diffusion en profondeur.

14. Procédé selon la revendication 13, dans lequel les premier et deuxième dopants sont diffusés dans le substrat semi-conducteur (200) jusqu'à la profondeur de la couche isolante (250).

15. Procédé selon la revendication 13 ou 14, comprenant les étapes consistant à fournir une première couche d'arrêt (262) par-dessus la première couche de matériau de dopage (261) et fournir une deuxième couche d'arrêt (264) par-dessus la deuxième couche de matériau de dopage (263) avant l'étape de diffusion des dopants appartenant aux première et deuxième couches de matériau de dopage dans le substrat semi-conducteur (200).
